# EUROPEAN PATENT APPLICATION

(11) **EP 2 899 684 A1**
(43) Date of publication of application: **29.07.2015**
(21) Application number: 15150712.6
(22) Date of filing: 09.01.2015
(51) Int. Cl.: G06Q 50/04, G06Q 50/06, G06Q 10/06

(54) **Energy efficiency evaluation support device, non-transitory computer-readable storage medium storing computer program, and method for supporting energy efficiency evaluation**

(30) Priority: 27.01.2014 JP 2014012302
(71) Applicant: Yokogawa Electric Corporation, Tokyo 180-8750 (JP)
(72) Inventor: Inoue, Ken-ichi, Tokyo, 180-8750 (JP)
(74) Representative: Henkel, Breuer & Partner

(57) **Abstract**

An energy efficiency evaluation support device according to one aspect of the present invention includes a data collector configured to collect actual values of an energy consumption index to be evaluated and actual values of at least one relevant variable and an evaluation display image generator configured to generate a display image for evaluating energy efficiency. The display image includes one axis for the actual values of the energy consumption index and the other axis for model calculated values of the energy consumption index. The model calculated values are calculated from the actual values of the at least one relevant variable using a model representing a correlation between the energy consumption index and the at least one relevant variable.

## Description

### BACKGROUND OF THE INVENTION

### Field of the Invention

The present invention relates to an energy efficiency evaluation support device for supporting energy efficiency evaluation, a non-transitory computer-readable storage medium storing a computer program, and a method for supporting energy efficiency evaluation.

Priority is claimed on Japanese Patent Application No. 2014-012302, filed January 27, 2014, the contents of which are incorporated herein by reference.

### Description of Related Art

Requirements for energy reduction in a production operation in a factory or the like have been further increased. In order to promote the energy reduction, it is necessary to evaluate energy efficiency. Therefore, in order to visualize the energy efficiency and make the energy efficiency easier to evaluate, a method for displaying a correlation between the energy consumption and the data related to the production operation has been used.

As the data related to the production operation, various items, for example, production quantity, a kind of a product or a raw material, operational status of each facility, circumstances such as temperature and weather, have been used. In particular, a correlation between energy consumption and production quantity has been widely used in the evaluation of energy efficiency. Further, a specific energy consumption, which is obtained by dividing the energy consumption by the production quantity, is a representative index, which indicates energy efficiency.

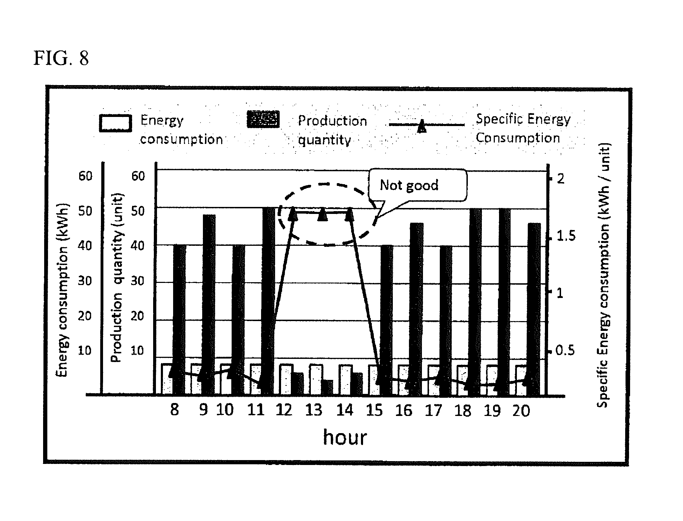

Therefore, a tool for supporting an energy operation in a factory or the like has provided a display image for displaying a correlation between energy consumption and production quantity. For example, FIG. 8 is a display image example where energy consumption, production quantity, and specific energy consumption are displayed simultaneously along a time axis. By using such a display image, it is possible to confirm the variation of energy efficiency along the time axis and to managing the objective. In addition, in occurrence of abnormality, it is possible to use the display image to clear the reason of abnormality.

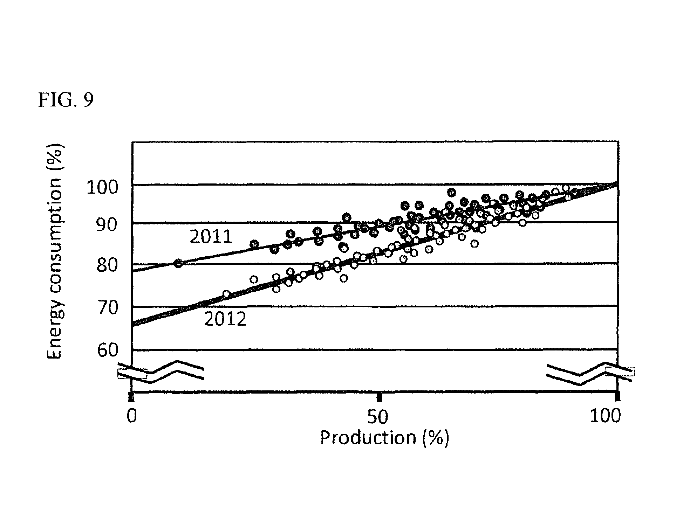

FIG. 9 is a display image example where a vertical axis is for energy consumption, a horizontal axis is for production quantity, and summary values for every predetermined period are plotted. By using such a display image, it is possible to visually display the energy efficiency. In addition, it is possible to visualize a base load, which is energy required even if the production quantity is equal to zero and fixedly consumed. In the display image example shown in FIG. 9, the energy consumption and the production quantity are displayed as a percentage, however, they are often displayed using an actual number.

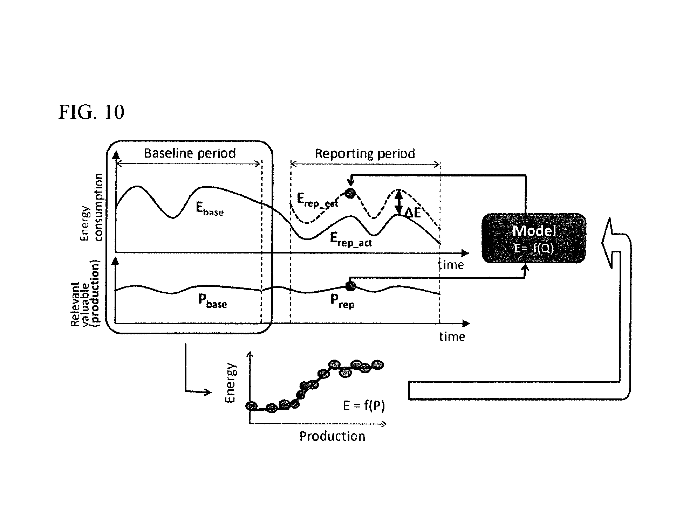

FIG. 10 is a display image where model values of energy consumption (dash line) for a reporting period are compared to actual values (solid line). The model values of energy consumption are calculated using the actual values of production quantity for the reporting period and a model where a correlation between production quantity (Q), which is a relevant variable, and energy consumption (E) is defined as E = f (Q) for a baseline period. Using such a display image, it is possible to visualize the effect of energy efficiency (improvement) measures.

As described above, various display methods for evaluating energy efficiency have been proposed. For example, Japanese Patent Application Laid-Open Publication No. 2010-271825 discloses an energy management system for collecting energy consumption data in a plurality of departments and displaying the ranking of energy consumption for every department. However, in a company producing various kinds of products such as a raw steel and a steel pipe, and a plastic pellet and a paint, since the correlation between the production quantity and the energy consumption is complicate, it is difficult to visualize the correlation using one graph. In addition, there are some cases where not only the consideration of production quantity, but also consideration of various factors is desired in order to evaluate energy efficiency from several perspectives, or intuitive recognition of improvement or degradation of energy efficiency is desired. Therefore, further diversification of display method is required.

### SUMMARY OF THE INVENTION

One aspect of the present invention provides an energy efficiency evaluation support device for displaying a new display image for evaluating energy efficiency, a non-transitory computer-readable storage medium storing a computer program, and a method for supporting energy efficiency evaluation.

An energy efficiency evaluation support device according to a first aspect of the present invention may include a data collector configured to collect actual values of an energy consumption index to be evaluated and actual values of at least one relevant variable and an evaluation display image generator configured to generate a display image for evaluating energy efficiency. The display image may include one axis for the actual values of the energy consumption index and the other axis for model calculated values of the energy consumption index. The model calculated values may be calculated from the actual values of the at least one relevant variable using a model representing a correlation between the energy consumption index and the at least one relevant variable.

In the energy efficiency evaluation support device according to the first aspect, the model may mathematically represent the correlation between the energy consumption index and a plurality of relevant variables.

In the energy efficiency evaluation support device according to the first aspect, the energy consumption index may be any one of a value of energy consumption, a value obtained by normalizing the energy consumption, and a value obtained by converting the energy consumption to another quantity.

In the energy efficiency evaluation support device according to the first aspect, the relevant variables may include any one of total production quantity, production quantity by products, temperature and a variable related to weather.

In the energy efficiency evaluation support device according to the first aspect, the evaluation display image generator may be configured to generate a display image for evaluating energy efficiency including a baseline having a slope of 45 degrees between the one axis and the other axis.

A non-transitory computer-readable storage medium storing a computer program according to a second aspect of the present invention which, when executed, may cause a computer to act as a data collector configured to collect actual values of an energy consumption index to be evaluated and actual values of at least one relevant variable and an evaluation display image generator configured to generate a display image for evaluating energy efficiency. The display image may include one axis for the actual values of the energy consumption index and the other axis for model calculated values of the energy consumption index. The model calculated values may be calculated from the actual values of the at least one relevant variable using a model representing a correlation between the energy consumption index and the at least one relevant variable.

In the non-transitory computer-readable storage medium storing the computer program according to the second aspect, the model may mathematically represent the correlation between the energy consumption index and a plurality of relevant variables.

In the non-transitory computer-readable storage medium storing the computer program according to the second aspect, the energy consumption index may be any one of a value of energy consumption, a value obtained by normalizing the energy consumption, and a value obtained by converting the energy consumption to another quantity.

In the non-transitory computer-readable storage medium storing the computer program according to the second aspect, the relevant variables may include any one of total production quantity, production quantity by products, temperature and a variable related to weather.

In the non-transitory computer-readable storage medium storing the computer program according to the second aspect, the evaluation display image generator may be configured to generate a display image for evaluating energy efficiency including a baseline having a slope of 45 degrees between the one axis and the other axis.

A method executed in a computer for supporting energy efficiency evaluation according to a third aspect of the present invention may include collecting actual values of an energy consumption index to be evaluated and actual values of at least one relevant variable and generating a display image for evaluating energy efficiency. The display image may include one axis for the actual values of the energy consumption index and the other axis for model calculated values of the energy consumption index. The model calculated values may be calculated from the actual values of the at least one relevant variable using a model representing a correlation between the energy consumption index and the at least one relevant variable.

In the method for supporting the energy efficiency evaluation according to the third aspect, the model may mathematically represent the correlation between the energy consumption index and a plurality of relevant variables.

In the method for supporting the energy efficiency evaluation according to the third aspect, the energy consumption index may be any one of a value of energy consumption, a value obtained by normalizing the energy consumption, and a value obtained by converting the energy consumption to another quantity.

In the method for supporting the energy efficiency evaluation according to the third aspect, the relevant variables may include any one of total production quantity, production quantity by products, temperature and a variable related to weather.

In the method for supporting the energy efficiency evaluation according to the third aspect, generating the display image for evaluating energy efficiency evaluation may include generating a display image for evaluating energy efficiency including a baseline having a slope of 45 degrees between the one axis and the other axis.

According to one aspect of the present invention, an energy efficiency evaluation support device for displaying a new display image for evaluating energy efficiency, a non-transitory computer-readable storage medium storing a computer program, and a method for supporting energy efficiency evaluation are provided.

### BRIEF DESCRIPTION OF THE DRAWINGS

FIG. 1 is a block diagram showing the configuration of an energy efficiency evaluation support device according to one embodiment of the present invention.
FIG. 2 is a diagram describing a display image for evaluating energy efficiency according to the embodiment of the present invention.
FIG. 3 is a diagram showing a display image example, which includes data plotted when the energy efficiency improves or degrades, of the display image for evaluating energy efficiency according to the embodiment of the present invention.
FIG. 4 is a diagram showing a display image example, which includes data plotted when energy efficiency for a baseline period is not different from that for a reporting period, of the display image for evaluating energy efficiency according to the embodiment of the present invention.
FIG. 5 is a diagram showing a display image example, which includes data plotted when the energy efficiency proportional to the production quantity improves, of the display image for evaluating energy efficiency according to the embodiment of the present invention.
FIG. 6 is a diagram showing a display image example, which includes data plotted when the base load is reduced, of the display image for evaluating energy efficiency according to the embodiment of the present invention.
FIG. 7 is a flowchart describing a work flow for evaluating energy efficiency using the energy efficiency evaluation support device according to the embodiment of the present invention.
FIG. 8 is a display image example where energy consumption, production quantity, and specific energy consumption are simultaneously displayed along a time axis.
FIG. 9 is a display image example where a vertical axis is for energy consumption, a horizontal axis is for production quantity, and summary values for every predetermined period are plotted.
FIG. 10 is a display image where predicted values of energy consumption are compared to actual values of energy consumption for the reporting period.

### DETAILED DESCRIPTION OF THE INVENTION

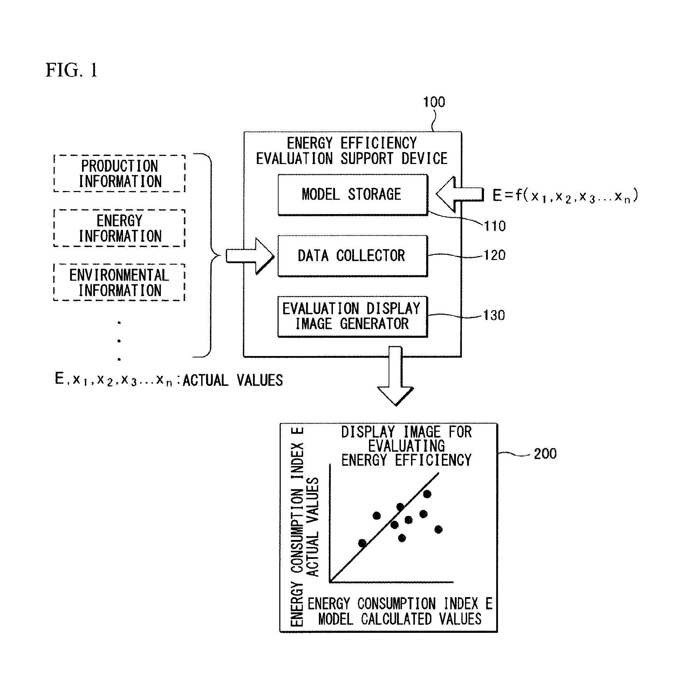

Hereinafter, one embodiment of the present invention will be described, with references made to the drawings. FIG. 1 is a block diagram showing the configuration of an energy efficiency evaluation support device 100 according to the present embodiment. As shown in FIG. 1, the energy efficiency evaluation support device 100 includes a model storage 110, a data collector 120, and an evaluation display image generator 130.

The energy efficiency evaluation support device 100 includes, for example, one or several computers configured to operate based on a computer program and a peripheral device such as an external storage device, a monitor, and input and output device. The computer may be a general-purpose personal computer, or a specialized computer for support of energy operation.

The model storage 110 stores a model, which mathematically represents a correlation between an energy consumption index and one or several relevant variables and is input by a worker. The energy consumption index is obtained by quantifying energy consumption. For example, the energy consumption index may be energy consumption itself, or may be a value obtained by normalizing the energy consumption or a value obtained by converting the energy consumption to another quantity.

As the relevant variables, various variables related to production activity including, for example, total production quantity, production quantity by products, temperature, and a variable related to circumstances such as weather may be adopted. When the model is defined, the relevant variable may be selected using a principal component analysis using a multivariate statistics, a multiple regression analysis, or the like.

Generally, the model is represented by an equation, E = f (x₁, x₂, x₃, ... xₙ). In the equation, the "E" indicates an energy consumption index, and the "x₁, x₂, x₃, ... xₙ" indicates the relevant variables. The period for acquiring the values of the relevant variable and the energy consumption index used to generate the model is referred to as a "baseline period".

For example, when production quantity p is adapted as a relevant variable, a model defined as E=a*p+b may be adopted. The "a" and "b" are defined by performing a regression analysis using actual values of an energy consumption index E and the production quantity p. In this case, the "b" indicates a base load.

When production quantity pA of a product A and production quantity pB of a product B are adapted as the relevant variables, a model defined as E=c*pA+ d*pB+e may be adopted. Obviously, a more complicated model may be adapted. By performing such a modelization, for example, when the energy required for producing the product A is quite different from that of the product B, it is possible to evaluate the energy efficiency in consideration of the variation in balance of production quantity.

The data collector 120 collects the actual values of the relevant variables adapted to the model stored in the model storage 110 and the actual values of the energy consumption index. The actual values may be summed, for example, every hour, day, week, or year. These relevant variables may be automatically acquired from a management system in a factory or the like, and may be input based on a worker's operation.

The evaluation display image generator 130 generates a display image for evaluating energy efficiency 200 based on the actual values of the relevant variables and the energy consumption index collected by the data collector 120 and the model stored in the model storage 110, and output the display image for evaluating energy efficiency 200. As the aspect of the output of the display image for evaluating energy efficiency 200, displaying the display image on a display device, printing the display image, recording the display image as electrical data, transmitting the display image to another device, or the like may be adopted.

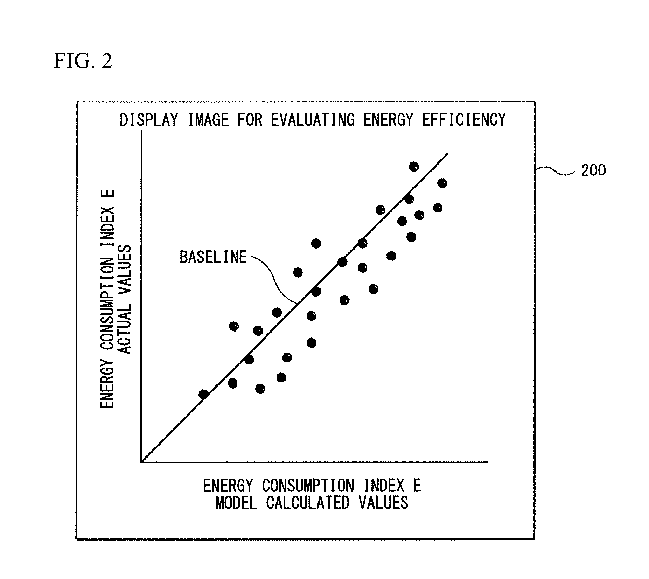

As shown in FIG. 2, in the display image for evaluating energy efficiency 200, the vertical axis is for the actual values of the energy consumption index E, the horizontal axis is for the model calculated values of the energy consumption index E obtained from the actual values of the relevant variables using the model, and the actual values are plotted. A line having a slope of 45 degrees in the display image is referred to as a baseline. The period for acquiring the actual values used for the calculation of the energy consumption index E using the model is referred to as a "reporting period".

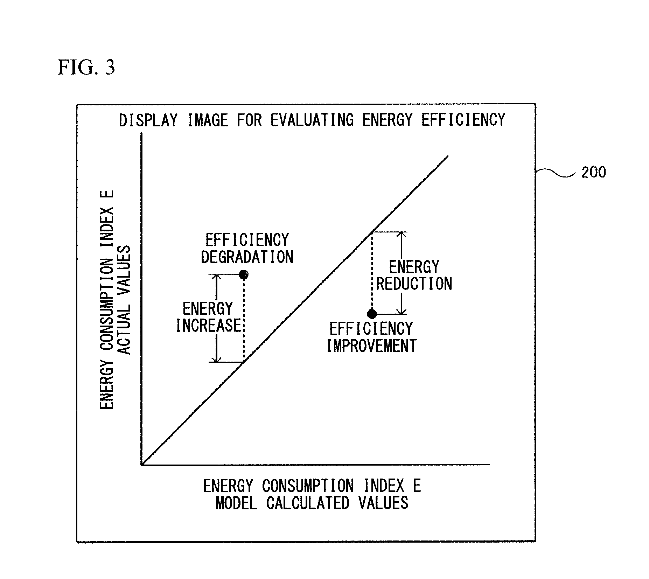

As shown in FIG. 3, in the display image for evaluating energy efficiency 200, when the plot points are positioned below the baseline, this means that the energy efficiency improved compare with that for the baseline period. In this case, the distance from the baseline to the plot point along the vertical axis means the degree of energy reduction. When the energy consumption is used as the energy consumption index, the distance from the baseline to the plot point along the vertical axis means the reduced energy quantity. On the other, when the ratio is used as the energy consumption index, the distance from the baseline to the plot point along the vertical axis means the energy reduction ratio.

On the other hand, when the plot points are positioned above the baseline, this means that the energy efficiency degraded compare with that for the baseline period. In this case, the distance from the baseline to the plot point along the vertical axis means the degree of energy increase.

As described above, the display image for evaluating energy efficiency 200 according to the present embodiment enables, not only easily and visually recognizing the effect of energy reduction, but also, easily and visually recognizing energy reduction quantity and energy reduction ratio. Therefore, the display image for evaluating energy efficiency 200 according to the present embodiment serves for the intuitive and easy-to-understand evaluation of energy efficiency from several perspectives.

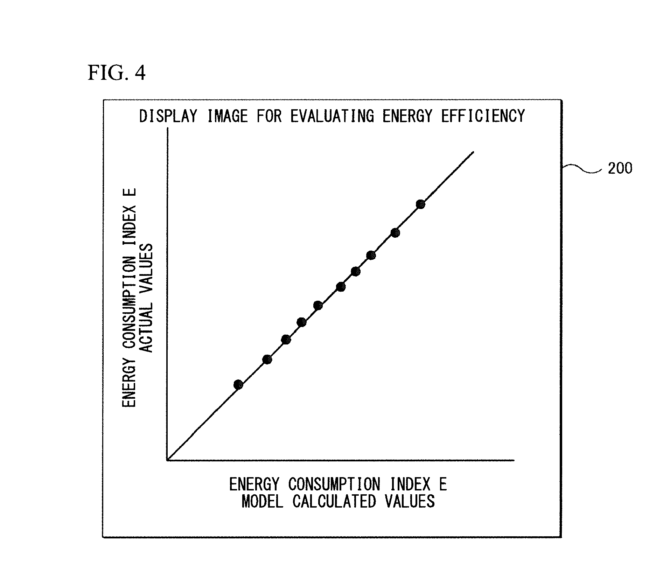

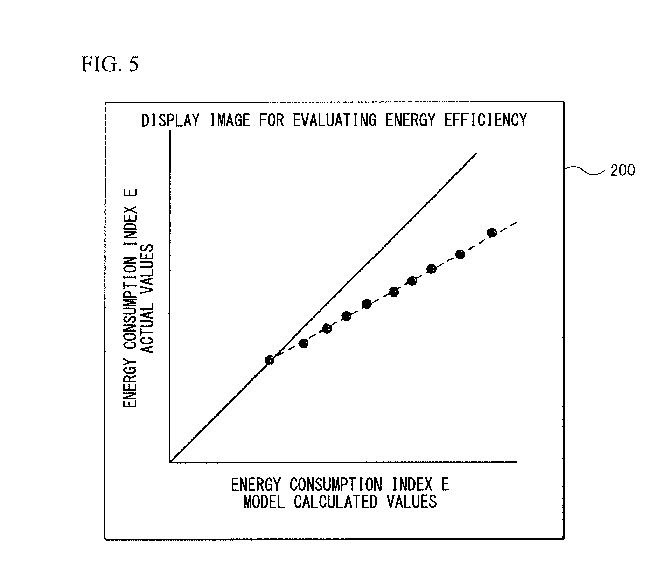

When the energy efficiency for the baseline period is not different from that of the reporting period, the plot points are on the baseline as shown in FIG. 4. Using this feature, it is possible to confirm the accuracy of the model. As shown in FIG. 5, when a line having a small slope compared to the baseline is obtained by plotting the actual values, this means that the energy efficiency proportional to the production quantity improves.

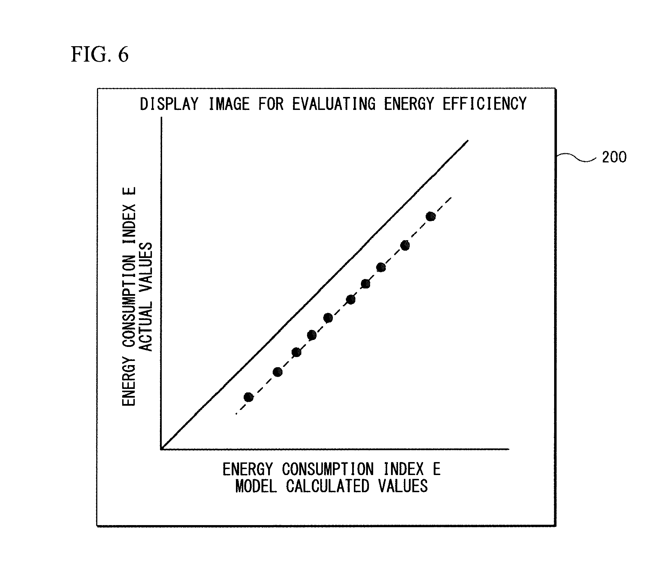

As shown in FIG. 6, when a line having the same slope as that of the baseline and shifted downward compared to the baseline is obtained by plotting the actual values, this means that the base load is reduced. In the display image for evaluating energy efficiency 200, the vertical axis and the horizontal axis may be interchanged, and the baseline may be inclined 45 degrees so as to be horizontal. In addition, a time axis as a third axis may be set in order to display a continuous variation.

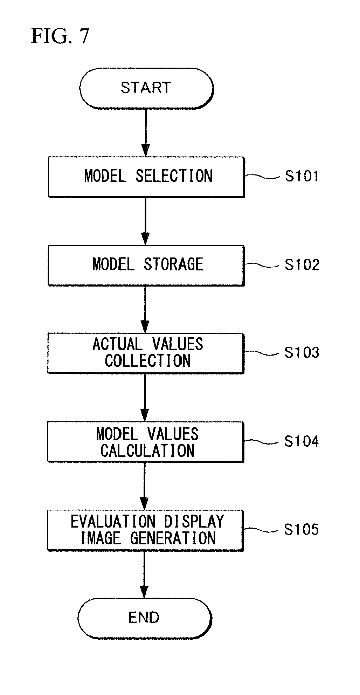

FIG. 7 is a flowchart describing a work flow for evaluating energy efficiency using the energy efficiency evaluation support device according to the present embodiment.

First, a model representing an energy consumption index is selected (S101). An existing model or a modified model obtained by modifying an existing model may be used as the model. Alternatively, a new model may be generated.

When a model is newly generated, data to be candidates for relevant variables is collected, data adapted as the relevant variables is extracted from the collected data, and a model representing a correlation between the relevant variables and the energy consumption index, for example, an equation is generated. When the candidates for relevant variables are collected, data thought to affect the energy consumption index and data where the consideration of the effect is desired may be optionally collected. Obviously, a model may be generated by other measures. In addition, a function for generating a model may be added to the energy efficiency evaluation support device 100.

The selected model is stored in the model storage 110 provided in the energy efficiency evaluation support device 100 (S102). The stored model may be updated and modified at an optional timing.

The data collector 120 collects actual values of the relevant variables and the energy consumption index for the reporting period (S103). The collection of the actual values may be performed by real-time processing or batch processing.

Next, model calculated values of the energy consumption index are calculated using the model and the actual values of the relevant variables (S104). Then, the display image for evaluating energy efficiency 200 where the horizontal axis is for the model calculated values of the energy consumption index E and the vertical axis is for the actual values of the energy consumption index E is generated and output (S105).

The model storage 110 provided in the energy efficiency evaluation support device 100 may include, for example, a volatile or non-volatile memory. The data collector 120 and the evaluation display image generator 130 provided in the energy efficiency evaluation support device 100 may be implemented by the execution by a non-shown MPU (microprocessing unit) provided in the energy efficiency evaluation support device 100 of a program for the implementation of the each function. That is, the data collector 120 and the evaluation display image generator 130 may be implemented by software and hardware resources operating in concert.

The program to implement the above-noted functions may be distributed in a condition of being recorded in a computer-readable recording medium such as, for example, a CD-ROM or DVD(registered trademark)-ROM or distributed via an external network such as the Internet. The various functions provided in the energy efficiency evaluation support device 100 may be implemented by software by reading out and installing the program recorded in a recording medium, or by downloading the program from an external network and installing it.

Although the foregoing has been a description of the energy efficiency evaluation support device, the non-transitory computer-readable storage medium storing a computer program, and the method for supporting an energy efficiency evaluation according to the embodiment of the present invention, the present invention is not limited to the embodiment described above, and can be freely modified within the scope of the present invention.

## Claims

1. An energy efficiency evaluation support device, comprising:
a data collector configured to collect actual values of an energy consumption index to be evaluated and actual values of at least one relevant variable; and
an evaluation display image generator configured to generate a display image for evaluating energy efficiency, the display image including one axis for the actual values of the energy consumption index and the other axis for model calculated values of the energy consumption index, the model calculated values being calculated from the actual values of the at least one relevant variable using a model representing a correlation between the energy consumption index and the at least one relevant variable.

2. The energy efficiency evaluation support device according to claim 1, wherein the model mathematically represents the correlation between the energy consumption index and a plurality of relevant variables.

3. The energy efficiency evaluation support device according to claim 1 or claim 2, wherein the energy consumption index is any one of a value of energy consumption, a value obtained by normalizing the energy consumption, and a value obtained by converting the energy consumption to another quantity.

4. The energy efficiency evaluation support device according to claim 2, wherein the relevant variables include any one of total production quantity, production quantity by products, temperature and a variable related to weather.

5. The energy efficiency evaluation support device according to any one of claims 1 to 4, wherein the evaluation display image generator is configured to generate a display image for evaluating energy efficiency including a baseline having a slope of 45 degrees between the one axis and the other axis.

6. A non-transitory computer-readable storage medium storing a computer program which, when executed, causes a computer to act as:
a data collector configured to collect actual values of an energy consumption index to be evaluated and actual values of at least one relevant variable; and
an evaluation display image generator configured to generate a display image for evaluating energy efficiency, the display image including one axis for the actual values of the energy consumption index and the other axis for model calculated values of the energy consumption index, the model calculated values being calculated from the actual values of the at least one relevant variable using a model representing a correlation between the energy consumption index and the at least one relevant variable.

7. The non-transitory computer-readable storage medium storing the computer program according to claim 6, wherein the model mathematically represents the correlation between the energy consumption index and a plurality of relevant variables.

8. The non-transitory computer-readable storage medium storing the computer program according to claim 6 or claim 7, wherein the energy consumption index is any one of a value of energy consumption, a value obtained by normalizing the energy consumption, and a value obtained by converting the energy consumption to another quantity.

9. The non-transitory computer-readable storage medium storing the computer program according to claim 7, wherein the relevant variables include any one of total production quantity, production quantity by products, temperature and a variable related to weather.

10. The non-transitory computer-readable storage medium storing the computer program according to any one of claims 6 to 9, wherein the evaluation display image generator is configured to generate a display image for evaluating energy efficiency including a baseline having a slope of 45 degrees between the one axis and the other axis.

11. A method executed in a computer for supporting energy efficiency evaluation, the method comprising:
collecting actual values of an energy consumption index to be evaluated and actual values of at least one relevant variable; and
generating a display image for evaluating energy efficiency, the display image including one axis for the actual values of the energy consumption index and the other axis for model calculated values of the energy consumption index, the model calculated values being calculated from the actual values of the at least one relevant variable using a model representing a correlation between the energy consumption index and the at least one relevant variable.

12. The method for supporting energy efficiency evaluation according to claim 11, wherein the model mathematically represents the correlation between the energy consumption index and a plurality of relevant variables.

13. The method for supporting energy efficiency evaluation according to claim 11 or claim 12, wherein the energy consumption index is any one of a value of energy consumption, a value obtained by normalizing the energy consumption, and a value obtained by converting the energy consumption to another quantity.

14. The method for supporting energy efficiency evaluation according to claim 12, wherein the relevant variables include any one of total production quantity, production quantity by products, temperature and a variable related to weather.

15. The method for supporting energy efficiency evaluation according to any one of claims 11 to 14, wherein generating the display image for evaluating energy efficiency evaluation comprises generating a display image for evaluating energy efficiency including a baseline having a slope of 45 degrees between the one axis and the other axis.
